# EUROPEAN PATENT APPLICATION

(11) **EP 3 882 657 A1**
(43) Date of publication of application: **22.09.2021**
(21) Application number: 19885384.8
(22) Date of filing: 06.11.2019
(51) Int. Cl.: G01S 7/484, G01C 3/06, G01S 7/497, G01S 17/36, H03K 5/04

(54) **SIGNAL PROCESSING DEVICE AND SIGNAL PROCESSING METHOD**

(30) Priority: 15.11.2018 JP 2018214817
(71) Applicant: Sony Semiconductor Solutions Corporation, Atsugi-shi, Kanagawa 243-0014 (JP)
(72) Inventor: MAEDA Shunji, Atsugi-shi, Kanagawa 243-0014 (JP)
(74) Representative: Müller Hoffmann & Partner
(86) International application number: PCT/JP2019/043381
(87) International publication number: WO 2020/100673

(57) **Abstract**

The present technology relates to a signal processing apparatus and a signal processing method that allow easy adjustment of a pulse duty ratio.

A phase comparison section outputs a phase difference signal corresponding to a phase difference between rising edges or falling edges of a first pulse and a second pulse. The first pulse is used as a basis at the time of adjusting a duty ratio, and the second pulse has a duty ratio that is to be adjusted. A reference signal generation section outputs a reference signal that starts changing according to the first pulse. A comparison section outputs a comparison output signal representing a magnitude relation between the phase difference signal and the reference signal, and the comparison output signal is fed back as the second pulse. The present technology is applicable to a case of adjusting a duty ratio of a pulse.

## Description

### [Technical Field]

The present technology relates to a signal processing apparatus and a signal processing method, and particularly, to a signal processing apparatus and a signal processing method that allow easy adjustment of a pulse duty ratio.

### [Background Art]

For example, in a distance measurement apparatus that measures a distance by an indirect TOF (Time Of Flight) technique, a distance measurement error occurs if a relative relation between a light emission timing of a light source that emits light and a light reception timing of a TOF sensor that receives reflected light emitted from the light source deviates from what the relation should be. Accordingly, the light emission timing of the light source or the light reception timing of the TOF sensor is adjusted by delaying a pulse for driving the light source or the TOF sensor (for example, see PTL 1).

### [Citation List]

### [Patent Literature]

[PTL 1]
JP 2009-236657A

### [Summary]

### [Technical Problem]

In a distance measurement apparatus, not only the relative relation between the light emission timing of the light source and the light reception timing of the TOF sensor but also a change in a width of a pulse for driving the light source and the TOF sensor affects distance measurement errors.

The present technology has been devised in light of such circumstances, and it is an object of the present technology to allow easy adjustment of a pulse duty ratio.

### [Solution to Problem]

A first signal processing apparatus of the present technology includes a phase comparison section, a reference signal generation section, and a comparison section. The phase comparison section outputs a phase difference signal corresponding to a phase difference between rising edges or falling edges of a first pulse and a second pulse. The first pulse is used as a basis at the time of adjusting a duty ratio, and the second pulse has a duty ratio that is to be adjusted. The reference signal generation section outputs a reference signal that starts changing according to the first pulse. The comparison section outputs a comparison output signal representing a magnitude relation between the phase difference signal and the reference signal. The comparison output signal is fed back as the second pulse.

A first signal processing method of the present technology includes outputting a phase difference signal corresponding to a phase difference between rising edges or falling edges of a first pulse and a second pulse, the first pulse being used as a basis at the time of adjusting a duty ratio, the second pulse having a duty ratio that is to be adjusted; outputting a reference signal that starts changing according to the first pulse; outputting a comparison output signal representing a magnitude relation between the phase difference signal and the reference signal; and feeding back the comparison output signal as the second pulse.

In the first signal processing apparatus and the first signal processing method of the present technology, the phase difference signal that corresponds to the phase difference between the rising edges or the falling edges of the first pulse, which is used as a basis at the time of adjusting the duty ratio, and the second pulse, which has the duty ratio that is to be adjusted, is output, and the reference signal that starts changing according to the first pulse is output. Then, the comparison output signal that represents the magnitude relation between the phase difference signal and the reference signal is output, and the comparison output signal is fed back as the second pulse.

A second signal processing apparatus of the present technology includes a phase comparison section, a reference signal generation section, a comparison section, another phase comparison section, another reference signal generation section, and another comparison section. The phase comparison section outputs a phase difference signal corresponding to a phase difference between either rising edges or falling edges of a first pulse and a second pulse. The first pulse is used as a basis at the time of adjusting a duty ratio, and the second pulse has a duty ratio that is to be adjusted. The reference signal generation section outputs a reference signal that starts changing according to the first pulse. The comparison section outputs a comparison output signal representing a magnitude relation between the phase difference signal and the reference signal. The other phase comparison section outputs another phase difference signal corresponding to a phase difference between the other of either the rising edges or the falling edges of the comparison output signal and the second pulse. The other reference signal generation section outputs another reference signal that starts changing according to the comparison output signal. The other comparison section outputs another comparison output signal representing a magnitude relation between the other phase difference signal and the other reference signal. The other comparison output signal is fed back as the second pulse.

A second signal processing method of the present technology includes outputting a phase difference signal corresponding to a phase difference between either rising edges or falling edges of a first pulse and a second pulse, the first pulse being used as a basis at the time of adjusting a duty ratio, the second pulse having a duty ratio that is to be adjusted; outputting a reference signal that starts changing according to the first pulse; outputting a comparison output signal representing a magnitude relation between the phase difference signal and the reference signal; outputting another phase difference signal corresponding to a phase difference between the other of either the rising edges or the falling edges of the comparison output signal and the second pulse; outputting another reference signal that starts changing according to the comparison output signal; outputting another comparison output signal representing a magnitude relation between the other phase difference signal and the other reference signal; and feeding back the other comparison output signal as the second pulse.

In the second signal processing apparatus and the second signal processing method of the present technology, the phase difference signal that corresponds to the phase difference between either the rising edges or the falling edges of the first pulse, which is used as a basis at the time of adjusting the duty ratio, and the second pulse, which has the duty ratio is to be adjusted, is output, and the reference signal that starts changing according to the first pulse is output. Further, the comparison output signal that represents the magnitude relation between the phase difference signal and the reference signal is output, and the other phase difference signal that corresponds to the phase difference between the other of either the rising edges or the falling edges of the comparison output signal and the second pulse is output. Also, the other reference signal that starts changing according to the comparison output signal is output, and the other comparison output signal that represents the magnitude relation between the other phase difference signal and the other reference signal is output. Then, the other comparison output signal is fed back as the second pulse.

It should be noted that the first and second signal processing apparatuses may be apparatuses independent of each other (including modules or semiconductor chips) or internal blocks included in a single apparatus.

### [Brief Description of Drawings]

[FIG. 1]

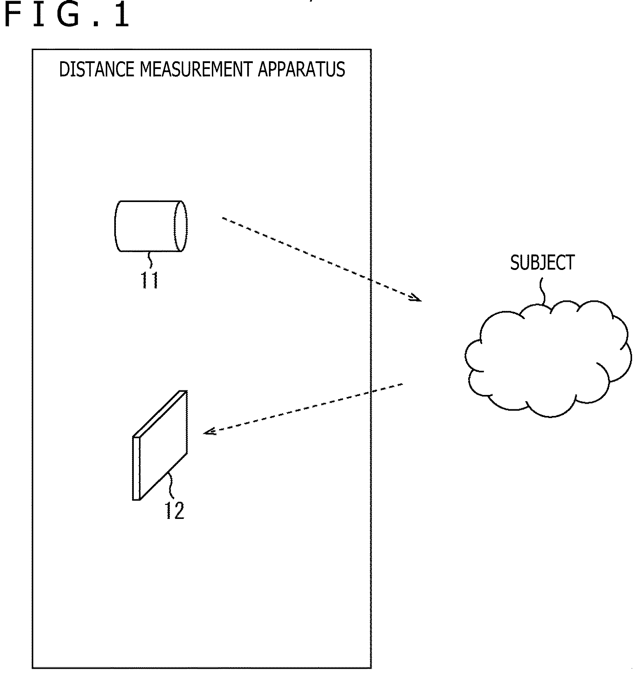

   FIG. 1 is a diagram outlining a configuration example of a distance measurement apparatus to which the present technology is applicable.
[FIG. 2]

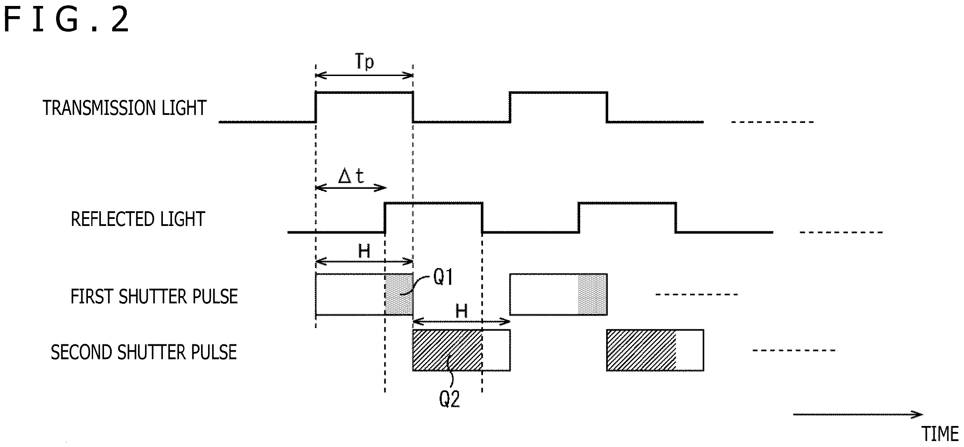

   FIG. 2 is a diagram describing an example of a distance measurement method by an indirect TOF technique.
[FIG. 3]

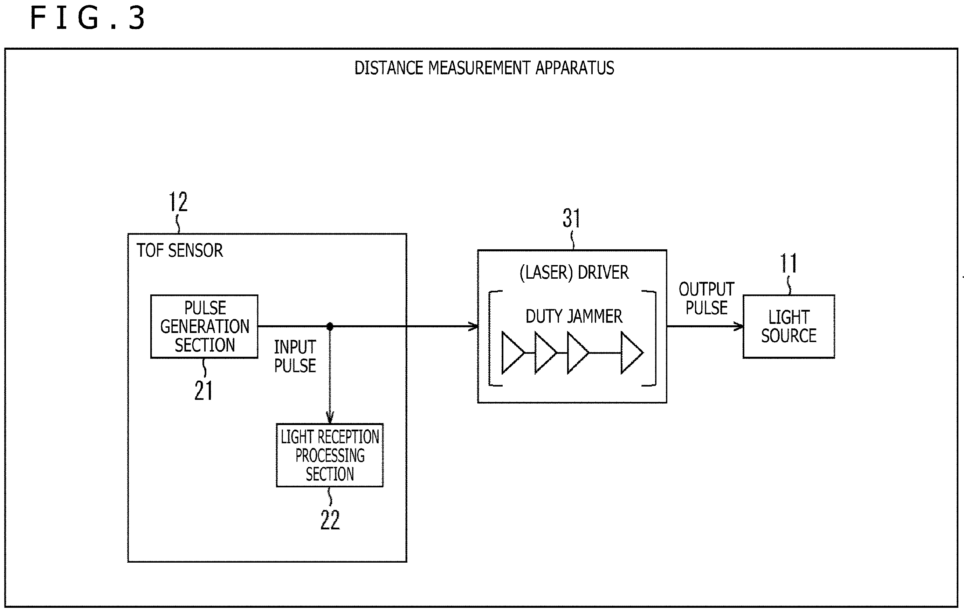

   FIG. 3 is a block diagram illustrating a first configuration example of a TOF sensor 12.
[FIG. 4]

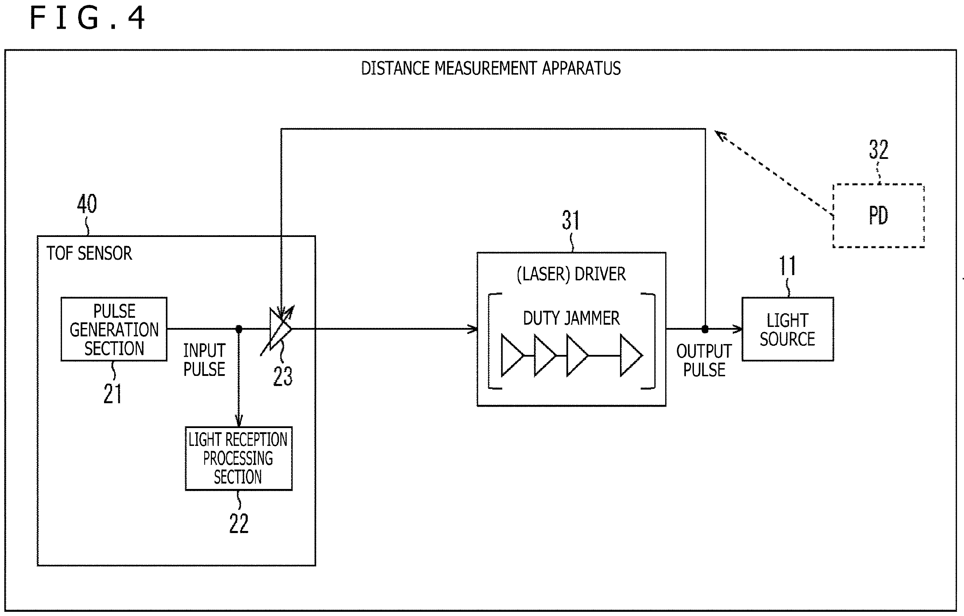

   FIG. 4 is a block diagram illustrating a second configuration example of the TOF sensor 12.
[FIG. 5]

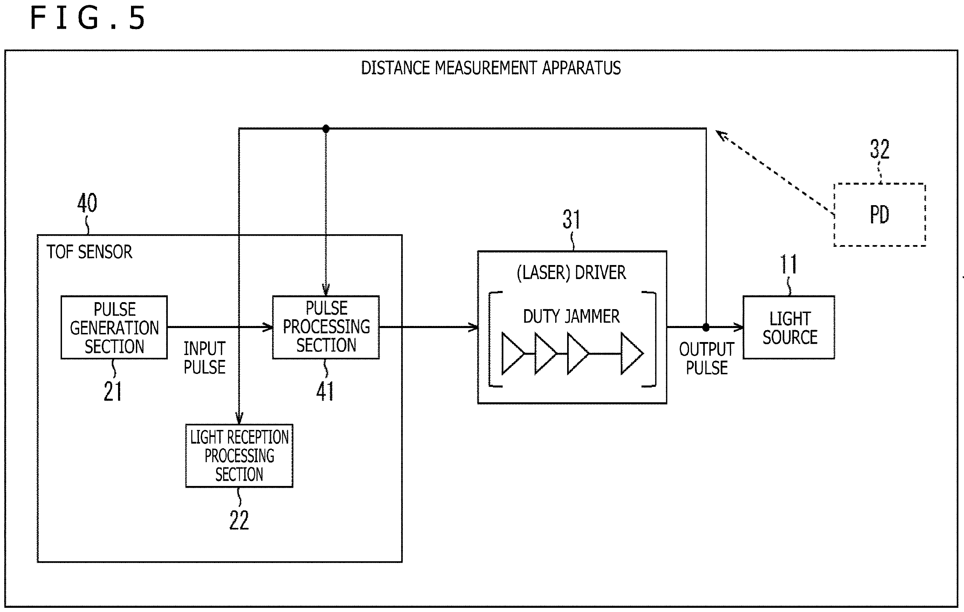

   FIG. 5 is a block diagram illustrating a configuration example of an embodiment of the distance measurement apparatus to which the present technology is applied.
[FIG. 6]

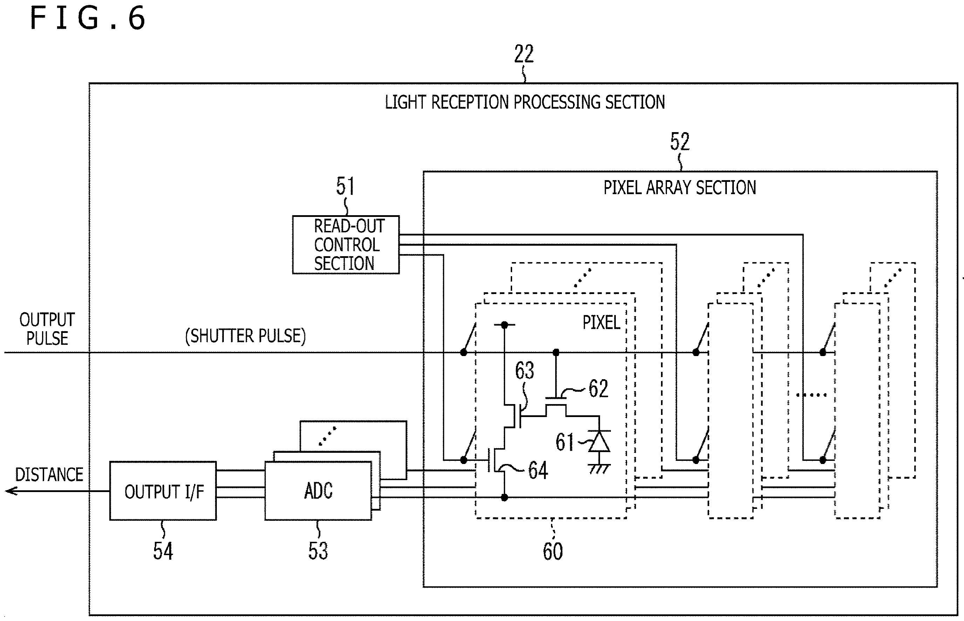

   FIG. 6 is a block diagram illustrating a configuration example of a light reception processing section 22.
[FIG. 7]

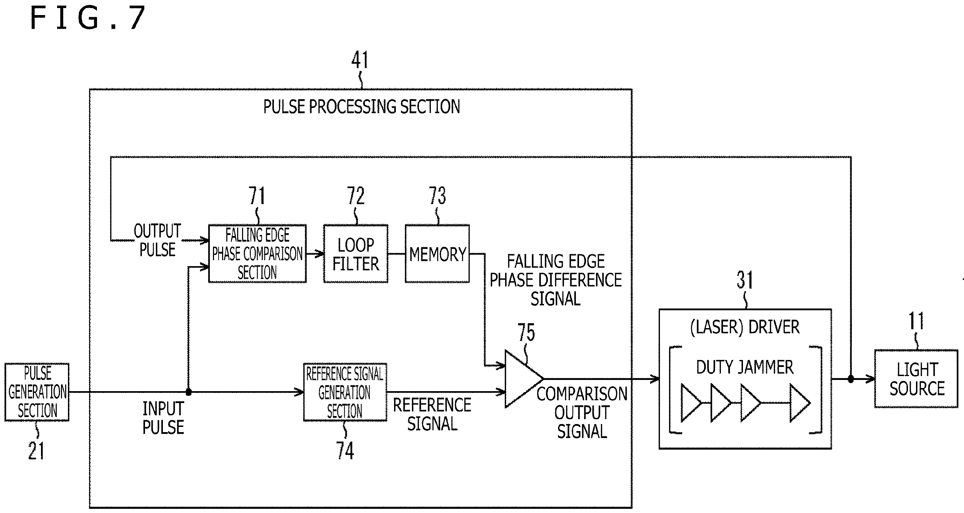

   FIG. 7 is a block diagram illustrating a first configuration example of a pulse processing section 41.
[FIG. 8]

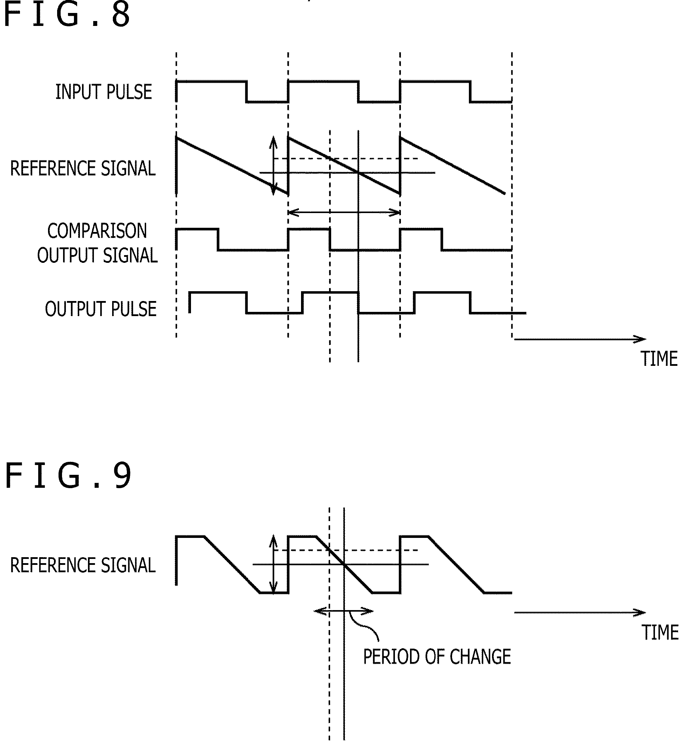

   FIG. 8 is a waveform diagram describing pulse processing operation of the pulse processing section 41.
[FIG. 9]
   FIG. 9 is a diagram describing a manner in which jitter occurring in a comparison output signal output from a comparator 75 is suppressed.
[FIG. 10]

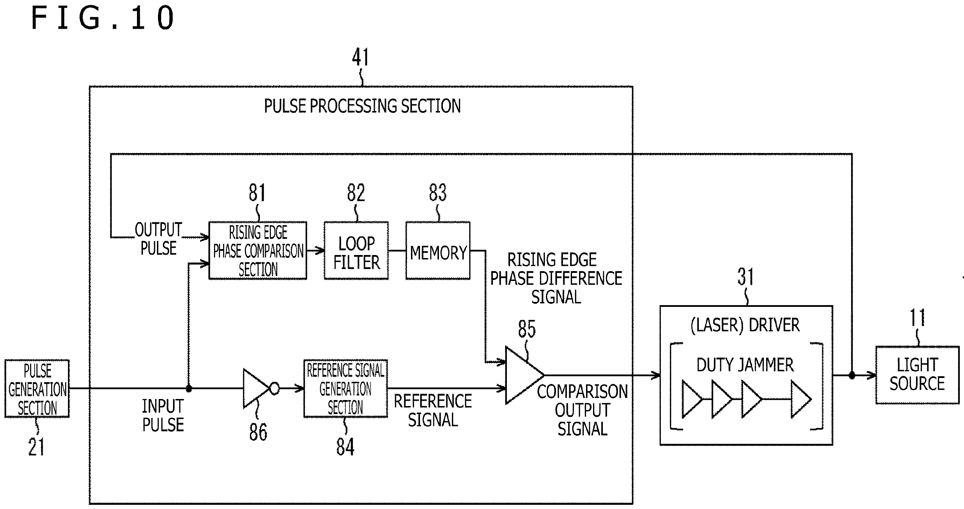

   FIG. 10 is a block diagram illustrating a second configuration example of the pulse processing section 41.
[FIG. 11]

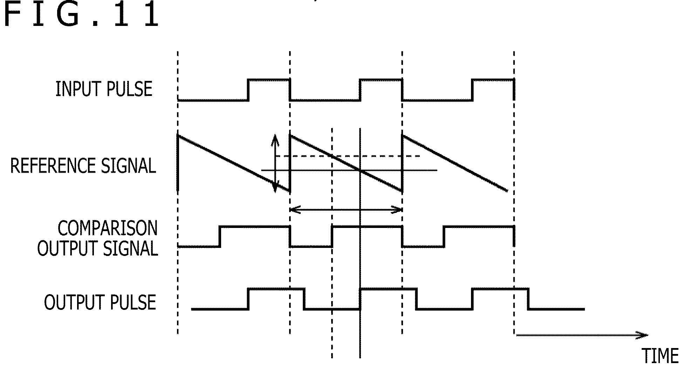

   FIG. 11 is a waveform diagram describing pulse processing operation of the pulse processing section 41.
[FIG. 12]

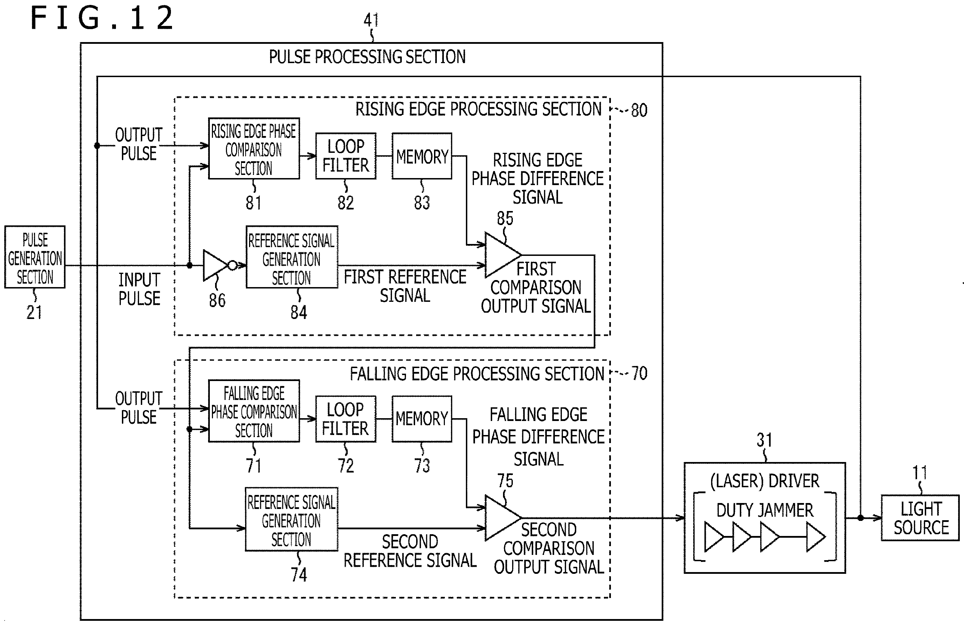

   FIG. 12 is a block diagram illustrating a third configuration example of the pulse processing section 41.
[FIG. 13]

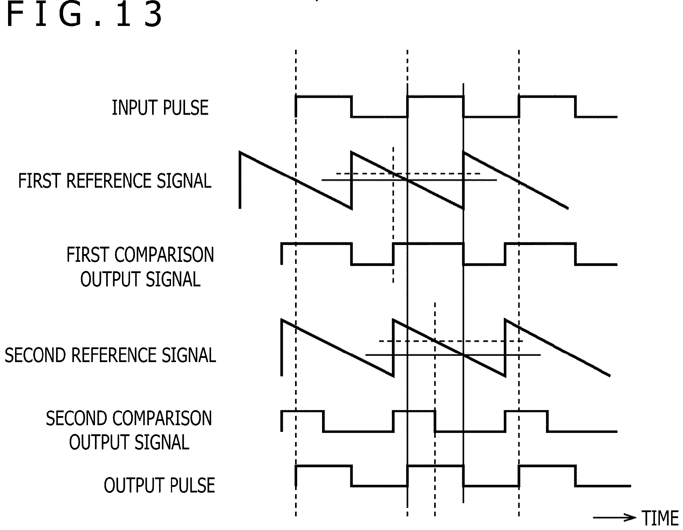

   FIG. 13 is a waveform diagram describing pulse processing operation of the pulse processing section 41.
[FIG. 14]

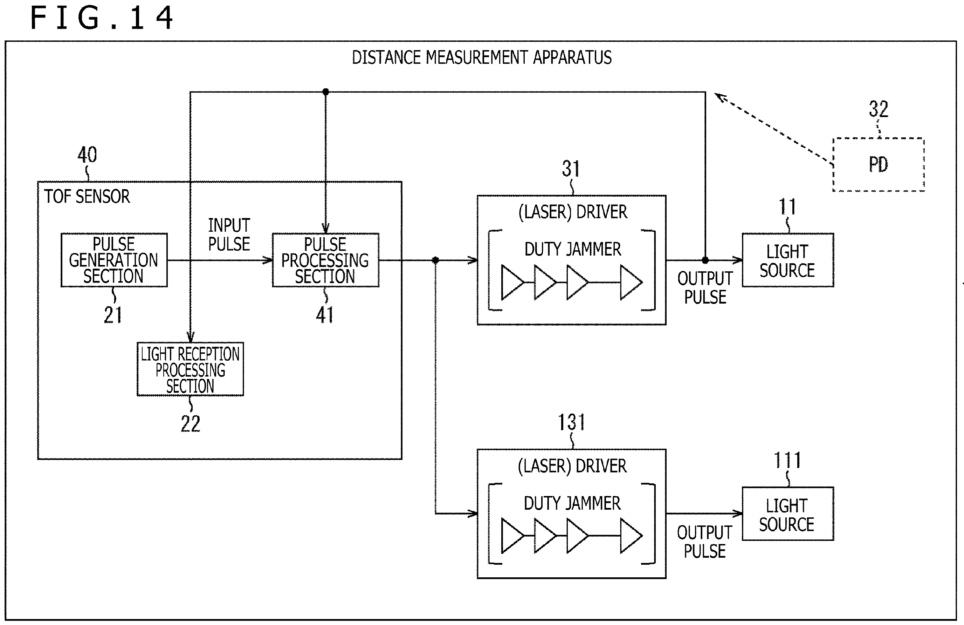

   FIG. 14 is a block diagram illustrating a configuration example of a first other embodiment of the distance measurement apparatus to which the present technology is applied.
[FIG. 15]

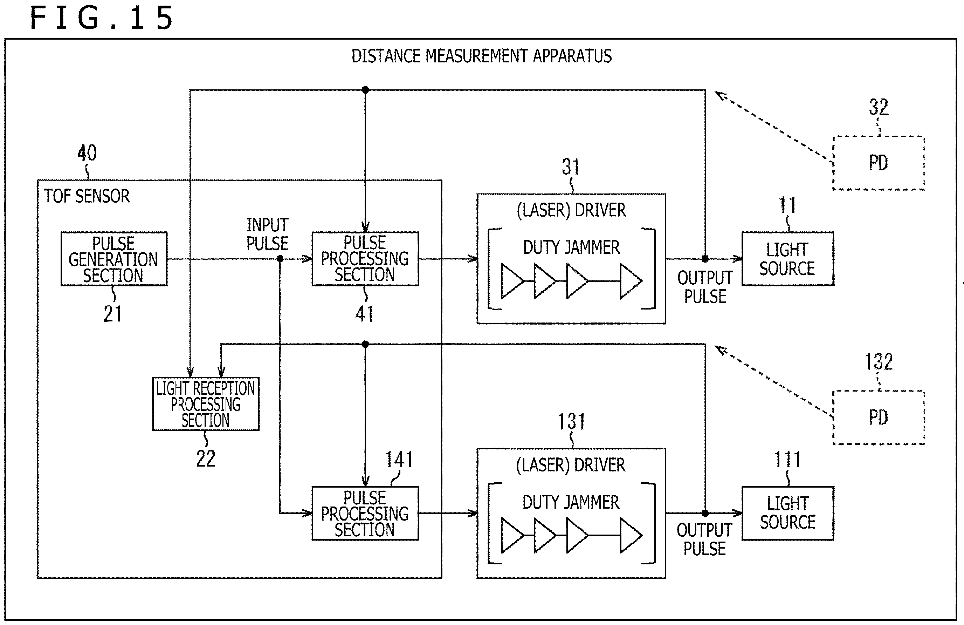

   FIG. 15 is a block diagram illustrating a configuration example of a second other embodiment of the distance measurement apparatus to which the present technology is applied.

### [Description of Embodiments]

### <Distance measurement apparatus to which the present technology is applicable>

FIG. 1 is a diagram outlining a configuration example of a distance measurement apparatus to which the present technology is applicable.

In FIG. 1, the distance measurement apparatus includes a light source 11 and a TOF sensor 12 and performs distance measurement to measure a distance to a subject, for example, by an indirect TOF technique.

The light source 11 emits, for example, light such as a laser beam. The TOF sensor 12 receives light that returns as reflected light after being emitted from the light source 11 and then reflected by the subject.

The TOF sensor 12 receives reflected light during a plurality of time periods based on light emission timings at which the light source 11 emits light, and calculates the distance to the subject according to an amount of reflected light (amount of charge) received during the plurality of time periods.

FIG. 2 is a diagram describing an example of a distance measurement method by the indirect TOF technique.

Here, light emitted by the light source 11 is also referred to as transmission light in the following description. For example, pulsed light in a pulse form is assumed to be used as the transmission light. It is also assumed that a pulse having the same pulse width and in the same phase as the pulsed light, which is the transmission light, is referred to as a first shutter pulse and that a pulse having the same pulse width as the pulsed light, which is the transmission light, but in a phase deviated from the transmission light by the pulse width of the transmission light is referred to as a second shutter pulse.

FIG. 2 illustrates examples of waveforms of transmission light, reflected light, and the first and second shutter pulses.

The TOF sensor 12 receives reflected light during a time period in which the first shutter pulse is at an H (High) level and during a time period in which the second shutter pulse is at an H level.

Now, it is assumed that the amount of charge of reflected light (amount of received light) received during the time period in which the first shutter pulse is at an H level is denoted as Q1 and that the amount of charge of reflected light (amount of received light) received during the time period in which the second shutter pulse is at an H level is denoted as Q2.

In such a case, assuming that a pulse width of transmission light is denoted as Tp, a delay time Δt of reflected light with respect to the transmission light can be obtained according to the formula Δt = Tp × Q2/(Q1 + Q2). Assuming that the speed of light is denoted as c[m/s], a distance L to a subject can be obtained according to the formula L = c × Δt/2.

FIG. 3 is a block diagram illustrating a first configuration example of the TOF sensor 12 illustrated in FIG. 1.

In FIG. 3, the TOF sensor 12 includes a pulse generation section 21 and a light reception processing section 22.

The pulse generation section 21 generates an input pulse for causing the light source 11 to emit transmission light and supplies the input pulse to the light reception processing section 22 and a driver 31.

Here, although not illustrated in FIG. 1, the driver 31 is included in the distance measurement apparatus illustrated in FIG. 1 together with the light source 11 and the TOF sensor 12.

The driver 31 is, for example, a laser driver configured to drive the (laser) light source 11 that emits a laser beam. The driver 31 generates an output pulse for driving the light source 11, according to the input pulse supplied from the pulse generation section 21, and supplies the output pulse to the light source 11. The light source 11 emits transmission light based on the output pulse. The transmission light emitted from the light source 11 returns as reflected light after reflection by a subject.

The light reception processing section 22 is driven according to the input pulse supplied from the pulse generation section 21 and receives reflected light from the subject. That is, as described with reference to FIG. 2, the light reception processing section 22 receives reflected light during the time period in which the first shutter pulse is at an H level and during the time period in which the second shutter pulse is at an H level, according to the input pulse supplied from the pulse generation section 21.

Then, the light reception processing section 22 obtains the distance to the subject according to the amount of charge of reflected light received during each of the time periods when the first and second shutter pulses are at an H level.

Incidentally, the driver 31 acts as a duty jammer that changes a duty ratio of the input pulse. Accordingly, even if the pulse generation section 21 generates, for example, an input pulse having a duty ratio of 50%, the duty ratio of an output pulse generated by the driver 31 according to the input pulse changes from 50%.

As described above, if the duty ratio of the output pulse that drives the light source 11 changes relative to the input pulse that drives the light reception processing section 22, the amount of charge of reflected light received during each of the time periods when the first and second shutter pulses are at an H level changes, thus resulting in distance measurement errors.

FIG. 4 is a block diagram illustrating a second configuration example of the TOF sensor 12 illustrated in FIG. 1.

It should be noted that, in FIG. 4, portions corresponding to those in the case of FIG. 3 are denoted by the same reference signs and that the description thereof will be omitted as appropriate in the following description.

In FIG. 4, the TOF sensor 12 includes the pulse generation section 21, the light reception processing section 22, and a delay adjustment circuit 23.

Accordingly, the TOF sensor 12 illustrated in FIG. 4 is similar to that described in the case of FIG. 3 in that the pulse generation section 21 and the light reception processing section 22 are provided. It should be noted, however, that the TOF sensor 12 illustrated in FIG. 4 differs from that described in the case of FIG. 3 in that the delay adjustment circuit 23 is newly provided.

The delay adjustment circuit 23 is supplied with an input pulse from the pulse generation section 21. Further, the delay adjustment circuit 23 is supplied with an output pulse that is to be supplied from the driver 31 to the light source 11.

The delay adjustment circuit 23 includes, for example, a DLL (Delay Locked Loop) or the like. According to the output pulse, the delay adjustment circuit 23 delays the input pulse supplied from the pulse generation section 21 in such a manner as to cancel (compensate for) a delay time occurring until the input pulse of the TOF sensor 12 reaches the light source 11 as an output pulse, and then, the delayed pulse is supplied to the driver 31.

As described above, the delay adjustment circuit 23 delays the input pulse supplied from the pulse generation section 21, according to the output pulse. This makes it possible to suppress distance measurement errors caused by a delay occurring until the input pulse of the TOF sensor 12 reaches the light source 11 as an output pulse.

It should be noted that the distance measurement apparatus can be provided with a PD (Photo Detector) 32 that detects transmission light emitted by the light source 11, as illustrated by a dotted line in the figure. In such a case, instead of an output pulse to be supplied to the light source 11, a pulse which corresponds to transmission light emitted by the light source 11 and detected by the PD 32 is fed back to the TOF sensor 12 (the delay adjustment circuit 23 thereof), thus allowing for the delay adjustment circuit 23 to adjust an amount of delay of the input pulse.

As described above, the delay adjustment circuit 23 can accurately adjust the amount of delay of the input pulse by feeding a pulse which corresponds to transmission light emitted by the light source 11 and detected by the PD 32, back to the TOF sensor 12 compared with a case of feeding the output pulse back to the TOF sensor 12.

While the output pulse is fed back to the TOF sensor in the distance measurement apparatus in the description given below, a pulse which corresponds to transmission light emitted by the light source 11 and detected by the PD 32 can also be fed back to the TOF sensor in the distance measurement apparatus described later instead of feeding back the output pulse.

In the TOF sensor 12 illustrated in FIG. 4, the delay adjustment circuit 23 adjusts the amount of delay of the input pulse as described above, thus making it possible to suppress distance measurement errors caused by a delay occurring until the input pulse of the TOF sensor 12 reaches the light source 11 as an output pulse.

However, the delay adjustment circuit 23 does not adjust the duty ratio of the input pulse, and therefore, it is difficult to suppress distance measurement errors caused by a change in the duty ratio of the output pulse that occurs in the driver 31 as described with reference to FIG. 3.

In the present technology, the input pulse that will turn into an output pulse is processed, thus adjusting the duty ratio of the output pulse with ease and suppressing distance measurement errors caused by a change in the duty ratio of the output pulse.

### <Embodiment of the distance measurement apparatus to which the present technology is applied>

FIG. 5 is a block diagram illustrating a configuration example of an embodiment of the distance measurement apparatus to which the present technology is applied.

It should be noted that, in FIG. 5, portions corresponding to those in the case of FIG. 4 are denoted by the same reference signs and that the description thereof will be omitted as appropriate.

In FIG. 5, the distance measurement apparatus includes the light source 11, the driver 31, and a TOF sensor 40.

Accordingly, the distance measurement apparatus illustrated in FIG. 5 is similar to that described in the case of FIG. 4 in that the light source 11 and the driver 31 are provided. It should be noted, however, that the distance measurement apparatus illustrated in FIG. 5 differs from that described in the case of FIG. 4 in that the TOF sensor 40 is provided in place of the TOF sensor 12.

The TOF sensor 40 includes the pulse generation section 21, the light reception processing section 22, and a pulse processing section 41.

Accordingly, the TOF sensor 40 is similar to the TOF sensor 12 illustrated in FIG. 4 in that the pulse generation section 21 and the light reception processing section 22 are provided. It should be noted, however, that the TOF sensor 40 differs from the TOF sensor 12 in that the delay adjustment circuit 23 is not provided but the pulse processing section 41 is newly provided. Further, the TOF sensor 40 also differs from the TOF sensor 12 in that an output pulse fed back to the TOF sensor 40 is supplied to the light reception processing section 22 instead of supplying an input pulse generated by the pulse generation section 21 and that the light reception processing section 22 is driven according to the output pulse.

It should be noted that, as described with reference to FIG. 4, the PD 32 may be provided in the distance measurement apparatus illustrated in FIG. 5, so that, instead of an output pulse, a pulse which corresponds to transmission light emitted by the light source 11 and detected by the PD 32 can be fed back to the TOF sensor 12. The distance measurement apparatus described later is arranged similarly.

In the case where, instead of an output pulse, a pulse which corresponds to transmission light emitted by the light source 11 and detected by the PD 32 is fed back to the TOF sensor 40, the duty ratio of pulsed light as transmission light emitted by the light source 11 can be more accurately adjusted.

The pulse processing section 41 is supplied with an input pulse from the pulse generation section 21. The pulse processing section 41 is a signal processing apparatus that handles a pulse processing task of processing an input pulse from the pulse generation section 21. The pulse processing section 41 processes the input pulse in such a manner as to set the duty ratio of the output pulse (or pulsed light as transmission light) to a desired duty ratio, and supplies the signal obtained as a result thereof to the driver 31.

### <Configuration example of the light reception processing section 22>

FIG. 6 is a block diagram illustrating a configuration example of the light reception processing section 22 illustrated in FIG. 5.

In FIG. 6, the light reception processing section 22 includes a read-out control section 51, a pixel array section 52, an ADC (AD (Analog to Digital) Converter) 53, and an output I/F (Interface) 54.

The read-out control section 51 controls read-out of electric signals from pixels 60 included in the pixel array section 52, by supplying a control signal to the pixel array section 52.

The pixel array section 52 includes the plurality of pixels 60 arranged in a two-dimensional planer pattern, for example. The pixel array section 52 is driven according to an output pulse fed back to the TOF sensor 40 and under the control of the read-out control section 51, receives reflected light, and outputs an electric signal corresponding to the amount of the reflected light.

The pixel 60 includes not only a PD (PhotoDiode) 61 but also a transfer transistor 62, an amplifying transistor 63, and a selection transistor 64 that each include an FET (Field Effect Transistor).

The PD 61 receives incident reflected light (light including the reflected light) and generates an electric signal corresponding to the amount of the reflected light.

The transfer transistor 62 is turned on or off according to the output pulse and transfers the electric signal generated by the PD 61 from the PD 61. The electric signal transferred from the PD 61 is supplied to a gate of the amplifying transistor 63.

The amplifying transistor 63 buffers the electric signal supplied to its gate.

The selection transistor 64 is turned on or off according to a control signal from the read-out control section 51, thereby turning on or off a connection between the amplifying transistor 63 and the ADC 53 (connecting the amplifying transistor 63 and the ADC 53 or disconnecting the two) .

When the connection between the amplifying transistor 63 and the ADC 53 is turned on, the electric signal is read out from the pixel 60. That is, the electric signal buffered by the amplifying transistor 63 is supplied to the ADC 53 via the selection transistor 64.

For example, the ADC 53 is provided in each column of the pixels 60 included in the pixel array section 52. The ADC 53 performs AD conversion on the electric signal that is supplied (read out) from the pixel 60 in the column in which the ADC 53 is provided, and then supplies the converted signal to the output I/F 54. The ADCs 53 equal in number to the number of columns of the pixels 60 included in the pixel array section 52 are provided, and each of the ADCs 53 performs AD conversion on an electric signal of the pixel 60 in a column in which a corresponding one of the ADCs 53 is provided, thus allowing for simultaneous AD conversion of electric signals of the pixels 60 in one row.

By using the electric signals from the ADCs 53, the output I/F 54 obtains a distance to a subject for each pixel 60, for example, as described with reference to FIG. 2 and outputs an image (distance image) having the distances as pixel values.

In the light reception processing section 22 configured as described above, according to an output pulse, the pixels 60 receive reflected light and output electric signals corresponding to the reflected light during each of the time periods when the first and second shutter pulses are at an H level as described with reference to FIG. 2.

The electric signals output from the pixels 60 are converted from analog to digital form by the ADCs 53 and supplied to the output I/F 54. The output I/F 54 obtains the distance to the subject for each pixel 60 by using the electric signals from the ADCs 53 and outputs a distance image having the distances as pixel values.

### <First configuration example of the pulse processing section 41>

FIG. 7 is a block diagram illustrating a first configuration example of the pulse processing section 41 illustrated in FIG. 5.

In FIG. 7, the pulse processing section 41 includes a falling edge phase comparison section 71, a loop filter 72, a memory 73, a reference signal generation section 74, and a comparator 75 but does not include a delay element such as the delay adjustment circuit 23 illustrated in FIG. 4.

The falling edge phase comparison section 71 is supplied with an output pulse fed back to the TOF sensor 40, as a pulse whose duty ratio is to be adjusted (second pulse). Further, the falling edge phase comparison section 71 is supplied with an input pulse from the pulse generation section 21, as a pulse used as a basis at the time of adjusting the duty ratio of the output pulse (first pulse).

The falling edge phase comparison section 71 compares phases of falling edges of the input and output pulses and outputs a falling edge phase difference signal that corresponds to the phase difference between the falling edges of the input and output pulses, to the loop filter 72.

The loop filter 72 filters the falling edge phase difference signal from the falling edge phase comparison section 71 and outputs the filtered falling edge phase difference signal to the memory 73.

The memory 73 (storage section) stores the falling edge phase difference signal from the loop filter 72 one after another in an overwriting fashion and outputs the signal to the comparator 75.

Here, the pulse processing section 41 can be configured without the memory 73. However, it should be noted that, in the case where the power is turned on with the memory 73 provided in the pulse processing section 41, it is possible to reduce the time required for the pulse processing section 41 to lock (to operate stably) by outputting the falling edge phase difference signal stored in the memory 73 at the time of previous power-off, to the comparator 75 as an initial value. The locked state of the pulse processing section 41 means the same state as the locked state that is referred to in connection with a PLL (Phase Locked Loop) used for synchronization of frequencies or phases, and refers, in FIG. 7, to a state in which the falling edges of the input and output pulses compared by the falling edge phase comparison section 71 match.

The reference signal generation section 74 is supplied with an input pulse from the pulse generation section 21.

The reference signal generation section 74 outputs, to the comparator 75, a reference signal that starts changing according to the input pulse from the pulse generation section 21. A ramp signal that decreases (or increases) at a constant rate can be used as a reference signal. It should be noted that, in addition to the ramp signal, a signal that changes so as to increase or decrease monotonously but not at a constant rate can be used as a reference signal, for example. In the present embodiment, a ramp signal that decreases at a constant rate is used as a reference signal.

The comparator 75 (comparison section) compares the falling edge phase difference signal from the memory 73 and the reference signal from the reference signal generation section 74 and outputs a comparison output signal representing a magnitude relation between the falling edge phase difference signal and the reference signal by an H level and an L level.

The comparison output signal output from the comparator 75 is supplied to the driver 31, and then, the signal is supplied to the light source 11 and fed back to the TOF sensor 40 as an output pulse.

FIG. 8 is a waveform diagram describing pulse processing operation of the pulse processing section 41 illustrated in FIG. 7.

The pulse generation section 21 generates an input pulse as a pulse for driving the light source 11. The input pulse generated by the pulse generation section 21 is supplied to the falling edge phase comparison section 71 and the reference signal generation section 74 of the pulse processing section 41.

The falling edge phase comparison section 71 compares the phases of the falling edges of the input pulse from the pulse generation section 21 and the output pulse fed back to the TOF sensor 40 and outputs a falling edge phase difference signal corresponding to the phase difference between the falling edges of the input and output pulses. The falling edge phase difference signal output from the falling edge phase comparison section 71 is supplied to the comparator 75 via the loop filter 72 and the memory 73.

Meanwhile, the reference signal generation section 74 generates, as a reference signal, a ramp signal that starts decreasing at a constant rate from a predetermined level at the timing of the rising edge of the input pulse and that has the same cycle as the input pulse, and supplies the ramp signal to the comparator 75.

The comparator 75 compares the falling edge phase difference signal and the reference signal and outputs a comparison output signal representing a magnitude relation between the falling edge phase difference signal and the reference signal. The comparison output signal output from the comparator 75 increases to an H level at the timing when the reference signal reaches a predetermined level (at the timing of the rising edge of the input pulse), and then decreases to an L level when the magnitude relation between the phase difference signal and the reference signal is reversed.

The comparison output signal output from the comparator 75 undergoes a change in the duty ratio as a result of passing through the driver 31 and is supplied to the light source 11 as an output pulse. Further, the output pulse is fed back to the TOF sensor 40.

The above pulse processing allows the pulse processing section 41 to lock such that the falling edge phase difference signal becomes 0, that is, such that the timings of the falling edges of the input and output pulses match.

The pulse processing section 41 illustrated in FIG. 7 can adjust the duty ratio of the output pulse to a desired duty ratio with ease by adjusting the input pulse.

Here, it is important that the duty ratio of the output pulse (pulsed light as transmission light) remains unchanged by PVT (process, voltage, and temperature). The pulse processing section 41 does not include any delay element susceptible to temperature change, thus making the pulse processing section 41 insusceptible to temperature change.

FIG. 9 is a diagram describing a manner in which jitter occurring in a comparison output signal output from the comparator 75 is suppressed.

In FIG. 8, the reference signal generation section 74 generates, as a reference signal, a ramp signal that starts decreasing at a constant rate from a predetermined level at the timing of the rising edge of the input pulse and that has the same cycle as the input pulse. In such a case, a period of change during which the reference signal changes includes the timing of one rising edge of the input pulse to the timing of a next rising edge (immediately before the next rising edge).

Here, a ramp signal that decreases at a constant rate from the timing of one rising edge of the input pulse to the timing of a next rising edge as described above is also referred to as a default signal.

The comparison output signal output from the comparator 75 is inverted if the magnitude relation between the falling edge phase difference signal and the reference signal is reversed. Accordingly, a slight change in the falling edge phase difference signal may result in jitter that changes the timing of inversion of the comparison output signal, i.e., the edge position of the pulse as a comparison output signal.

For this reason, the reference signal generation section 74 can adjust a period of change of the reference signal so that the period becomes shorter than that of the default signal.

For example, the reference signal generation section 74 can adjust the period of change of the reference signal so that the period becomes shorter than that of the default signal, by generating, as a reference signal, a ramp signal that reaches a predetermined level at the timing of the rising edge of the input pulse and that starts decreasing with a steeper slope than the default signal after the lapse of a predetermined period of time, as illustrated in FIG. 9.

As described above, by adjusting the period of change of the reference signal so that the period becomes shorter than that of the default signal, a slope of the reference signal becomes steep, thus suppressing jitter caused by a significant change in the timing of inversion of the comparison output signal resulting from a slight change in the falling edge phase difference signal.

It should be noted that the reference signal generation section 74 can adjust (set) the period of change of the reference signal, for example, according to an external instruction or the like.

The adjustment of the period of change of the reference signal corresponds to the adjustment of a cutoff frequency of the loop filter in a PLL.

### <Second configuration example of the pulse processing section 41>

FIG. 10 is a block diagram illustrating a second configuration example of the pulse processing section 41 illustrated in FIG. 5.

In FIG. 10, the pulse processing section 41 includes a rising edge phase comparison section 81, a loop filter 82, a memory 83, a reference signal generation section 84, a comparator 85, and an inverter 86 but does not include a delay element.

The rising edge phase comparison section 81 is supplied with an output pulse fed back to the TOF sensor 40, as a pulse whose duty ratio is to be adjusted (second pulse). Further, the rising edge phase comparison section 81 is supplied with an input pulse from the pulse generation section 21, as a pulse used as a basis at the time of adjusting the duty ratio of the output pulse (first pulse).

The rising edge phase comparison section 81 compares the phases of the rising edges of the input and output pulses and outputs a rising edge phase difference signal that corresponds to the phase difference between the rising edges of the input and output pulses, to the loop filter 82.

Here, although the falling edge phase comparison section 71 illustrated in FIG. 7 compares the phases of the falling edges of the input and output pulses, the rising edge phase comparison section 81 compares the phases of the rising edges of the input and output pulses.

The loop filter 82 filters the rising edge phase difference signal from the rising edge phase comparison section 81 and outputs the filtered rising edge phase difference signal to the memory 83, similarly to the loop filter 72 illustrated in FIG. 7.

The memory 83 (storage section) stores the rising edge phase difference signal from the loop filter 82 one after another in an overwriting fashion and outputs the signal to the comparator 85, similarly to the memory 73 illustrated in FIG. 7.

Here, the pulse processing section 41 illustrated in FIG. 10 can be configured without the memory 83, similarly to the case of FIG. 7. However, it should be noted that, in the case where the power is turned on with the memory 83 provided in the pulse processing section 41, it is possible to reduce the time required for the pulse processing section 41 to lock, by outputting the rising edge phase difference signal stored in the memory 83 at the time of previous power-off, to the comparator 85 as an initial value.

An input pulse supplied from the pulse generation section 21 is inverted by the inverter 86 and then supplied to the reference signal generation section 84.

The reference signal generation section 84 outputs, to the comparator 85, a reference signal that starts changing according to the input pulse supplied from the pulse generation section 21 via the inverter 86.

Here, the reference signal generation section 84 generates, as a reference signal, a ramp signal that starts decreasing from a predetermined level at a constant rate at the timing of the rising edge of the supplied pulse, similarly to the reference signal generation section 74 illustrated in FIG. 7, for example.

The reference signal generation section 84 is supplied with an input pulse from the pulse generation section 21 after inversion by the inverter 86. Accordingly, the reference signal generation section 84 generates a ramp signal that starts decreasing from a predetermined level at a constant rate at the timing of the falling edge of the input pulse instead of the rising edge thereof.

The comparator 85 (comparison section) compares the rising edge phase difference signal from the memory 83 and the reference signal from the reference signal generation section 84 and outputs a comparison output signal representing a magnitude relation between the rising edge phase difference signal and the reference signal by an H level and an L level.

The comparison output signal output from the comparator 85 is supplied to the driver 31, and then, the signal is supplied to the light source 11 and fed back to the TOF sensor 40 as an output pulse.

The inverter 86 inverts the input pulse supplied from the pulse generation section 21 and supplies the inverted pulse to the reference signal generation section 84.

Accordingly, assuming that the duty ratio of the input pulse is, for example, 50%, the reference signal generation section 84 generates a reference signal that has a phase deviated, by half the cycle of the input pulse, from the reference signal generated by the reference signal generation section 74 illustrated in FIG. 7.

FIG. 11 is a waveform diagram describing pulse processing operation of the pulse processing section 41 illustrated in FIG. 10.

The pulse generation section 21 generates an input pulse as a pulse for driving the light source 11. The input pulse generated by the pulse generation section 21 is supplied not only to the rising edge phase comparison section 81 of the pulse processing section 41 but also to the reference signal generation section 84 via the inverter 86.

The rising edge phase comparison section 81 compares the phases of the rising edges of the input pulse supplied from the pulse generation section 21 and the output pulse fed back to the TOF sensor 40 and outputs a rising edge phase difference signal that corresponds to the phase difference between the rising edges of the input and output pulses. The rising edge phase difference signal output from the rising edge phase comparison section 81 is supplied to the comparator 85 via the loop filter 82 and the memory 83.

Meanwhile, the reference signal generation section 84 generates, as a reference signal, a ramp signal that starts decreasing from a predetermined level at a constant rate of change at the timing of the rising edge of the pulse obtained by inverting the input pulse and supplied via the inverter 86, i.e., at the timing of the falling edge of the input pulse, and outputs the ramp signal to the comparator 85.

The comparator 85 compares the rising edge phase difference signal and the reference signal and outputs a comparison output signal representing a magnitude relation between the rising edge phase difference signal and the reference signal. The comparison output signal output from the comparator 85 decreases to an L level at the timing when the reference signal reaches a predetermined level (at the timing of the falling edge of the input pulse), and then increases to an H level when the magnitude relation between the phase difference signal and the reference signal is reversed.

The comparison output signal output from the comparator 85 undergoes a change in the duty ratio as a result of passing through the driver 31 and is supplied to the light source 11 as an output pulse. Further, the output pulse is fed back to the TOF sensor 40.

The above pulse processing allows the pulse processing section 41 to lock such that the rising edge phase difference signal becomes 0, that is, such that the timings of the rising edges of the input and output pulses match.

The pulse processing section 41 illustrated in FIG. 10 can also adjust the duty ratio of the output pulse to a desired duty ratio with ease by adjusting the input pulse, similarly to the case of FIG. 7.

Further, similarly to the case of FIG. 7, the pulse processing section 41 illustrated in FIG. 10 does not include any delay element, thus making the pulse processing section 41 insusceptible to temperature change.

It should be noted that, in the pulse processing section 41 illustrated in FIG. 10, the reference signal generation section 84 can also suppress jitter in the comparison output signal by adjusting the period of change of the reference signal as described with reference to FIG. 9.

### <Third configuration example of the pulse processing section 41>

FIG. 12 is a block diagram illustrating a third configuration example of the pulse processing section 41 illustrated in FIG. 5.

It should be noted that, in FIG. 12, portions corresponding to those in the case of FIGS. 7 and 10 are denoted by the same reference signs and that the description thereof will be omitted as appropriate.

In FIG. 12, the pulse processing section 41 includes the falling edge phase comparison section 71, the loop filter 72, the memory 73, the reference signal generation section 74, and the comparator 75 in addition to the rising edge phase comparison section 81, the loop filter 82, the memory 83, the reference signal generation section 84, the comparator 85, and the inverter 86 but does not include a delay element.

Accordingly, the pulse processing section 41 illustrated in FIG. 12 includes the falling edge phase comparison section 71 to the comparator 75 that are included in the pulse processing section 41 illustrated in FIG. 7, and the rising edge phase comparison section 81 to the inverter 86 that are included in the pulse processing section 41 illustrated in FIG. 10.

That is, the pulse processing section 41 illustrated in FIG. 12 is similar to that described in the case of FIG. 10 in that the rising edge phase comparison section 81 to the inverter 86 are provided. It should be noted, however, that the pulse processing section 41 illustrated in FIG. 12 differs from that described in the case of FIG. 10 in that the falling edge phase comparison section 71 to the comparator 75 illustrated in FIG. 7 are newly provided.

Here, in FIG. 12, the portion including the falling edge phase comparison section 71 to the comparator 75 is also referred to as a falling edge processing section 70, whereas the portion including the rising edge phase comparison section 81 to the inverter 86 is also referred to as a rising edge processing section 80.

Further, the reference signal output from the reference signal generation section 84 and the reference signal output from the reference signal generation section 74 are also referred to as a first reference signal and a second reference signal, respectively, and the comparison output signal output from the comparator 85 and the comparison output signal output from the comparator 75 are also referred to as a first comparison output signal and a second comparison output signal, respectively.

The pulse processing section 41 illustrated in FIG. 12 differs from that described in the case of FIG. 10 in that the first comparison output signal output from the comparator 85 is supplied to the falling edge processing section 70 instead of the driver 31 and that the second comparison output signal output from the comparator 75 is supplied to the driver 31.

It should be noted that, while, in FIG. 12, the falling edge processing section 70 and the rising edge processing section 80 are disposed in such an order that the input pulse supplied from the pulse generation section 21 is processed by the rising edge processing section 80 and then processed by the falling edge processing section 70, the falling edge processing section 70 and the rising edge processing section 80 can conversely be disposed in such an order that the input pulse is processed by the falling edge processing section 70 and then processed by the rising edge processing section 80.

Also, the pulse processing section 41 illustrated in FIG. 12 can be configured without the memory 73 or 83 as in the cases of FIGS. 7 and 10. In the case where the pulse processing section 41 includes no memory 73 or 83, the scale of the distance measurement apparatus can be reduced by the scale of the memory 73 or 83. On the other hand, in the case where the memory 73 or 83 is provided, it is possible to reduce the time required for the pulse processing section 41 to lock as described with reference to FIGS. 7 and 10.

FIG. 13 is a waveform diagram describing pulse processing operation of the pulse processing section 41 illustrated in FIG. 12.

The pulse generation section 21 generates an input pulse as a pulse for driving the light source 11. The input pulse generated by the pulse generation section 21 is supplied not only to the rising edge phase comparison section 81 of the pulse processing section 41 but also to the reference signal generation section 84 via the inverter 86.

The rising edge phase comparison section 81 compares the phases of the rising edges of the input pulse supplied from the pulse generation section 21 and the output pulse fed back to the TOF sensor 40 and outputs a rising edge phase difference signal that corresponds to the phase difference between the rising edges of the input and output pulses. The rising edge phase difference signal output from the rising edge phase comparison section 81 is supplied to the comparator 85 via the loop filter 82 and the memory 83.

Meanwhile, the reference signal generation section 84 generates, as a first reference signal, a ramp signal that starts decreasing from a predetermined level at a constant rate of change at the timing of the rising edge of the pulse obtained by inverting the input pulse and supplied via the inverter 86, i.e., at the timing of the falling edge of the input pulse, and outputs the ramp signal to the comparator 85.

The comparator 85 compares the rising edge phase difference signal and the first reference signal and outputs a comparison output signal representing a magnitude relation between the rising edge phase difference signal and the first reference signal. The comparison output signal output from the comparator 85 decreases to an L level at the timing when the first reference signal reaches a predetermined level (at the timing of the falling edge of the input pulse), and then increases to an H level when the magnitude relation between the rising edge phase difference signal and the first reference signal is reversed.

The first comparison output signal output from the comparator 85 is supplied to the falling edge phase comparison section 71 and the reference signal generation section 74.

The falling edge phase comparison section 71 compares the phases of the falling edges of the first comparison output signal output from the comparator 85 and the output pulse fed back to the TOF sensor 40 and outputs a falling edge phase difference signal that corresponds to the phase difference between the falling edges of the first comparison output signal and the output pulse. The falling edge phase difference signal output from the falling edge phase comparison section 71 is supplied to the comparator 75 via the loop filter 72 and the memory 73.

Meanwhile, the reference signal generation section 74 generates, as a second reference signal, a ramp signal that starts decreasing from a predetermined level at a constant rate of change at the timing of the rising edge of the first comparison output signal and outputs the ramp signal to the comparator 75.

The comparator 75 compares the falling edge phase difference signal and the second reference signal and outputs a second comparison output signal representing a magnitude relation between the falling edge phase difference signal and the second reference signal. The second comparison output signal output from the comparator 75 increases to an H level at the timing when the second reference signal reaches a predetermined level (at the timing of the rising edge of the first comparison output signal), and then decreases to an L level when the magnitude relation between the falling edge phase difference signal and the second reference signal is reversed.

The second comparison output signal output from the comparator 75 undergoes a change in the duty ratio as a result of passing through the driver 31 and is supplied to the light source 11 as an output pulse. Further, the output pulse is fed back to the TOF sensor 40.

The above pulse processing allows the pulse processing section 41 illustrated in FIG. 12 to lock such that the rising edge phase difference signal and the falling edge phase difference signal become 0, that is, such that the timings of the rising edges of the input and output pulses match and the timings of the falling edges thereof also match.

Therefore, the pulse processing section 41 illustrated in FIG. 12 can adjust the duty ratio of the output pulse to the duty ratio of the input pulse with ease. Further, according to the pulse processing section 41 illustrated in FIG. 12, not only the duty ratio but also the delay of the output pulse relative to the input pulse can be adjusted.

Further, similarly to the cases of FIGS. 7 and 10, the pulse processing section 41 illustrated in FIG. 12 does not include any delay element, thus making the pulse processing section 41 insusceptible to temperature change.

It should be noted that, in the pulse processing section 41 illustrated in FIG. 12, the reference signal generation sections 74 and 84 can also suppress jitter in the second comparison output signal by adjusting the periods of change of the reference signals as described with reference to FIG. 9.

### <Other embodiments of the distance measurement apparatus to which the present technology is applied>

FIG. 14 is a block diagram illustrating a configuration example of a first other embodiment of the distance measurement apparatus to which the present technology is applied.

It should be noted that, in FIG. 14, portions corresponding to those in the case of FIG. 5 are denoted by the same reference signs and that the description thereof will be omitted as appropriate.

In FIG. 14, the distance measurement apparatus includes the light source 11, the laser driver 31, the TOF sensor 40, a light source 111, and a driver 131.

Accordingly, the distance measurement apparatus illustrated in FIG. 14 is similar to that described in the case of FIG. 5 in that the light source 11, the laser driver 31, and the TOF sensor 40 are provided, and differs from that described in the case of FIG. 5 in that the light source 111 and the driver 131 are newly provided.

Similarly to the driver 31, the driver 131 generates an output pulse for driving the light source 111, according to a signal (comparison output signal) supplied from the pulse processing section 41, and supplies the output pulse to the light source 111. The light source 111 emits transmission light based on the output pulse supplied from the driver 131.

Here, in the distance measurement apparatus illustrated in FIG. 14, the light source 111 emits transmission light having the same wavelength as that of the light source 11.

As described above, in the case where the distance measurement apparatus includes the two light sources 11 and 111 as multiple light sources and where the multiple light sources 11 and 111 emit transmission light having the same wavelength, an output pulse to be supplied to any one of the multiple light sources, that is, the light source 11 or the light source 111, is fed back to the TOF sensor 40. By using the output pulse that is to be supplied to any one of the multiple light sources and is fed back to the TOF sensor 40, pulse processing can be performed in the pulse processing section 41 included in the TOF sensor 40.

It should be noted that three or more light sources configured to emit transmission light having the same wavelength can be provided in the distance measurement apparatus.

FIG. 15 is a block diagram illustrating a configuration example of a second other embodiment of the distance measurement apparatus to which the present technology is applied.

It should be noted that, in FIG. 15, portions corresponding to those in the case of FIG. 14 are denoted by the same reference signs and that the description thereof will be omitted as appropriate.

In FIG. 15, the distance measurement apparatus includes the light source 11, the laser driver 31, the TOF sensor 40, the light source 111, and the driver 131.

Accordingly, the distance measurement apparatus illustrated in FIG. 15 is configured in a similar manner to that described in the case of FIG. 14.

It should be noted, however, that the distance measurement apparatus illustrated in FIG. 15 differs from that described in the case of FIG. 14 in that the TOF sensor 40 includes, in addition to the pulse generation section 21, the light reception processing section 22, and the pulse processing section 41, a pulse processing section 141 configured in a similar manner to the pulse processing section 41. Further, the distance measurement apparatus illustrated in FIG. 15 differs from that described in the case of FIG. 14 in that not only the output pulse to be supplied to the light source 11 but also the output pulse to be supplied to the light source 111 is fed back to the TOF sensor 40.

Here, in the distance measurement apparatus illustrated in FIG. 15, the light source 111 emits transmission light having a different wavelength from that of the light source 11.

As descried above, in the case where the distance measurement apparatus includes the two light sources 11 and 111 as multiple light sources and where the multiple light sources 11 and 111 emit transmission light having different wavelengths, the pulse processing section 41 for the light source 11 and the pulse processing section 141 for the light source 111 can be provided in the TOF sensor 40. Further, the pulse processing section 41 for the light source 11 can perform pulse processing of generating a comparison output signal for the light source 11 by using the output pulse that is to be supplied to the light source 11 and is fed back to the TOF sensor 40, whereas the pulse processing section 141 for the light source 111 can perform pulse processing of generating a comparison output signal for the light source 111 by using the output pulse that is to be supplied to the light source 111 and is fed back to the TOF sensor 40. In such a case, the driver 31 generates the output pulse that drives the light source 11 according to the comparison output signal for the light source 11 generated by the pulse processing section 41, whereas the driver 131 generates the output pulse that drives the light source 111 according to the comparison output signal for the light source 111 generated by the pulse processing section 141.

It should be noted that three or more light sources configured to emit transmission light having different wavelengths can be provided in the distance measurement apparatus.

Further, in the distance measurement apparatus illustrated in FIG. 15, in the case where the PD 32 is provided in the light source 11 to detect transmission light emitted by the light source 11 and where, instead of the output pulse to be supplied to the light source 11, a pulse which corresponds to transmission light emitted by the light source 11 and detected by the PD 32 is fed back to the TOF sensor 40, a PD 132 can be provided in the light source 111 to detect transmission light emitted by the light source 111, and, instead of the output pulse to be supplied to the light source 111, a pulse which corresponds to transmission light emitted by the light source 111 and detected by the PD 132 can also be fed back to the TOF sensor 40.

It should be noted that embodiments of the present technology are not limited to the abovementioned embodiments and can be modified in various ways without departing from the gist of the present technology.

For example, the present technology is applicable to adjustment of the duty ratios of pulses used not only in distance measurement apparatuses but also in optical communication and the like.

Further, the advantageous effects described in the present specification are merely illustrative and are not restrictive, and there may be other advantageous effects.

It should be noted that the present technology can have the configurations described below.

<1> A signal processing apparatus including:
   a phase comparison section adapted to output a phase difference signal corresponding to a phase difference between rising edges or falling edges of a first pulse and a second pulse, the first pulse being used as a basis at a time of adjusting a duty ratio, the second pulse having a duty ratio that is to be adjusted;
   a reference signal generation section adapted to output a reference signal that starts changing according to the first pulse; and
   a comparison section adapted to output a comparison output signal representing a magnitude relation between the phase difference signal and the reference signal, in which
   the comparison output signal is fed back as the second pulse.
<2> The signal processing apparatus of feature <1>, further including:
   a loop filter adapted to filter the phase difference signal.
<3> The signal processing apparatus of feature <2>, further including:
   a storage section adapted to store the phase difference signal filtered by the loop filter.
<4> The signal processing apparatus of any one of features <1> to <3>, in which
   the reference signal generation section adjusts a period of change during which the reference signal changes.
<5> The signal processing apparatus of any one of features <1> to <4>, in which
   a light source that emits light to be received by a TOF (Time Of Flight) sensor is driven by the second pulse.
<6> A signal processing method including:
   outputting a phase difference signal corresponding to a phase difference between rising edges or falling edges of a first pulse and a second pulse, the first pulse being used as a basis at a time of adjusting a duty ratio, the second pulse having a duty ratio that is to be adjusted;
   outputting a reference signal that starts changing according to the first pulse;
   outputting a comparison output signal representing a magnitude relation between the phase difference signal and the reference signal; and
   feeding back the comparison output signal as the second pulse.
<7> A signal processing apparatus including:
   a phase comparison section adapted to output a phase difference signal corresponding to a phase difference between either rising edges or falling edges of a first pulse and a second pulse, the first pulse being used as a basis at a time of adjusting a duty ratio, the second pulse having a duty ratio that is to be adjusted;
   a reference signal generation section adapted to output a reference signal that starts changing according to the first pulse;
   a comparison section adapted to output a comparison output signal representing a magnitude relation between the phase difference signal and the reference signal;
   another phase comparison section adapted to output another phase difference signal corresponding to a phase difference between another of either the rising edges or the falling edges of the comparison output signal and the second pulse;
   another reference signal generation section adapted to output another reference signal that starts changing according to the comparison output signal; and
   another comparison section adapted to output another comparison output signal representing a magnitude relation between the other phase difference signal and the other reference signal, in which
   the other comparison output signal is fed back as the second pulse.
<8> The signal processing apparatus of feature <7>, further including:
   a loop filter adapted to filter the phase difference signal; and
   another loop filter adapted to filter the other phase difference signal.
<9> The signal processing apparatus of feature <8>, further including:
   a storage section adapted to store the phase difference signal filtered by the loop filter; and
   another storage section adapted to store the other phase difference signal filtered by the other loop filter.
<10> The signal processing apparatus of any one of features <7> to <9>, in which
   the reference signal generation section adjusts a period of change during which the reference signal changes, and
   the other reference signal generation section adjusts a period of change during which the other reference signal changes.
<11> The signal processing apparatus of any one of features <7> to <10>, in which
   a light source that emits light to be received by a TOF (Time Of Flight) sensor is driven by the second pulse.
<12> A signal processing method including:
   outputting a phase difference signal corresponding to a phase difference between either rising edges or falling edges of a first pulse and a second pulse, the first pulse being used as a basis at a time of adjusting a duty ratio, the second pulse having a duty ratio that is to be adjusted;
   outputting a reference signal that starts changing according to the first pulse;
   outputting a comparison output signal representing a magnitude relation between the phase difference signal and the reference signal;
   outputting another phase difference signal corresponding to a phase difference between the other of either the rising edges or the falling edges of the comparison output signal and the second pulse;
   outputting another reference signal that starts changing according to the comparison output signal;
   outputting another comparison output signal representing a magnitude relation between the other phase difference signal and the other reference signal; and
   feeding back the other comparison output signal as the second pulse.

### [Reference Signs List]

- 11:: Light source
- 12:: TOF sensor
- 21:: Pulse generation section
- 22:: Light reception processing section
- 23:: Delay adjustment circuit
- 31:: Driver
- 32:: PD
- 40:: TOF sensor
- 41:: Pulse processing section
- 51:: Read-out control section
- 52:: Pixel array section
- 53:: ADC
- 54:: Output I/F
- 61:: PD
- 62: to 64: FET
- 70:: Falling edge processing section
- 71:: Falling edge phase comparison section
- 72:: Loop filter
- 73:: Memory
- 74:: Reference signal generation section
- 75:: Comparator
- 80:: Rising edge processing section
- 81:: Rising edge phase comparison section
- 82:: Loop filter
- 83:: Memory
- 84:: Reference signal generation section
- 85:: Comparator
- 111:: Light source
- 131:: Driver
- 132:: PD

## Claims

1. A signal processing apparatus comprising:
a phase comparison section adapted to output a phase difference signal corresponding to a phase difference between rising edges or falling edges of a first pulse and a second pulse, the first pulse being used as a basis at a time of adjusting a duty ratio, the second pulse having a duty ratio that is to be adjusted;
a reference signal generation section adapted to output a reference signal that starts changing according to the first pulse; and
a comparison section adapted to output a comparison output signal representing a magnitude relation between the phase difference signal and the reference signal, wherein
the comparison output signal is fed back as the second pulse.

2. The signal processing apparatus of claim 1, further comprising:
a loop filter adapted to filter the phase difference signal.

3. The signal processing apparatus of claim 2, further comprising:
a storage section adapted to store the phase difference signal filtered by the loop filter.

4. The signal processing apparatus of claim 1, wherein
the reference signal generation section adjusts a period of change during which the reference signal changes.

5. The signal processing apparatus of claim 1, wherein
a light source that emits light to be received by a TOF (Time Of Flight) sensor is driven by the second pulse.

6. A signal processing method comprising:
outputting a phase difference signal corresponding to a phase difference between rising edges or falling edges of a first pulse and a second pulse, the first pulse being used as a basis at a time of adjusting a duty ratio, the second pulse having a duty ratio that is to be adjusted;
outputting a reference signal that starts changing according to the first pulse;
outputting a comparison output signal representing a magnitude relation between the phase difference signal and the reference signal; and
feeding back the comparison output signal as the second pulse.

7. A signal processing apparatus comprising:
a phase comparison section adapted to output a phase difference signal corresponding to a phase difference between either rising edges or falling edges of a first pulse and a second pulse, the first pulse being used as a basis at a time of adjusting a duty ratio, the second pulse having a duty ratio that is to be adjusted;
a reference signal generation section adapted to output a reference signal that starts changing according to the first pulse;
a comparison section adapted to output a comparison output signal representing a magnitude relation between the phase difference signal and the reference signal;
another phase comparison section adapted to output another phase difference signal corresponding to a phase difference between another of either the rising edges or the falling edges of the comparison output signal and the second pulse;
another reference signal generation section adapted to output another reference signal that starts changing according to the comparison output signal; and
another comparison section adapted to output another comparison output signal representing a magnitude relation between the other phase difference signal and the other reference signal, wherein
the other comparison output signal is fed back as the second pulse.

8. The signal processing apparatus of claim 7, further comprising:
a loop filter adapted to filter the phase difference signal; and
another loop filter adapted to filter the other phase difference signal.

9. The signal processing apparatus of claim 8, further comprising:
a storage section adapted to store the phase difference signal filtered by the loop filter; and
another storage section adapted to store the other phase difference signal filtered by the other loop filter.

10. The signal processing apparatus of claim 7, wherein
the reference signal generation section adjusts a period of change during which the reference signal changes, and
the other reference signal generation section adjusts a period of change during which the other reference signal changes.

11. The signal processing apparatus of claim 7, wherein
a light source that emits light to be received by a TOF (Time Of Flight) sensor is driven by the second pulse.

12. A signal processing method comprising:
outputting a phase difference signal corresponding to a phase difference between either rising edges or falling edges of a first pulse and a second pulse, the first pulse being used as a basis at a time of adjusting a duty ratio, the second pulse having a duty ratio that is to be adjusted;
outputting a reference signal that starts changing according to the first pulse;
outputting a comparison output signal representing a magnitude relation between the phase difference signal and the reference signal;
outputting another phase difference signal corresponding to a phase difference between another of either the rising edges or the falling edges of the comparison output signal and the second pulse;
outputting another reference signal that starts changing according to the comparison output signal;
outputting another comparison output signal representing a magnitude relation between the other phase difference signal and the other reference signal; and
feeding back the other comparison output signal as the second pulse.
